# EUROPÄISCHE PATENTSCHRIFT

(11) **EP 2 975 012 B1**
(45) Veröffentlichungstag und Bekanntmachung des Hinweises auf die Patenterteilung: **27.05.2020**
(21) Anmeldenummer: 14177717.7
(22) Anmeldetag: 18.07.2014
(51) Int. Cl.: C04B 41/87, C04B 41/89, C03C 17/25

(54) **Verfahren zur Herstellung elektrisch leitfähiger Beschichtungen**
Method for producing electrically conductive coatings
Procédé de fabrication de revêtements à conduction électrique

(43) Veröffentlichungstag der Anmeldung: 20.01.2016
(60) Teilanmeldung: 19180746.0
(73) Patentinhaber: ERLUS AKTIENGESELLSCHAFT, 84088 Neufahrn (DE)
(72) Erfinder: Bahnemann, Detlef, Prof. Dr., 30826 Garbsen (DE); Fleisch, Manuel, Dr., 30855 Langenhagen (DE); Gast, Eduard, Dr., 84559 Kraiburg (DE); Hacker, Alois, 84061 Ergoldsbach (DE); Ackerhans, Carsten, Dr., 84066 Mallersdorf-Pfaffenberg (DE); Stoll, Alexander, Dr., 85354 Freising (DE)
(74) Vertreter: Walcher, Armin

(56) Entgegenhaltungen:
- DE-A1- 3 742 373
- US-A- 2 692 836
- HUANG Y ET AL: "Investigation on structural, electrical and optical properties of tungsten-doped tin oxide thin films", THIN SOLID FILMS, ELSEVIER-SEQUOIA S.A. LAUSANNE, CH, Bd. 518, Nr. 8, 1. Februar 2010 (2010-02-01), Seiten 1892-1896, XP026877052, ISSN: 0040-6090 [gefunden am 2009-07-17]
- YANWEI HUANG ET AL: "Transparent conductive tungsten-doped tin oxide thin films synthesized by sol-gel technique on quartz glass substrates", JOURNAL OF SOL-GEL SCIENCE AND TECHNOLOGY, KLUWER ACADEMIC PUBLISHERS, BO, vol. 54, no. 3, 24 February 2010 (2010-02-24), pages 276-281, XP019824882, ISSN: 1573-4846

## Beschreibung

Die vorliegende Erfindung betrifft ein Verfahren zum Herstellen einer elektrisch leitfähigen Beschichtung umfassend Wolfram-dotiertes Zinnoxid.

Die Entwicklung transparenter leitfähiger Beschichtungen ist ein Feld intensiver Forschungsbemühungen. Ursache dieses großen Interesses ist vor allem das rasante Wachstum der Nachfrage nach Photovoltaikmodulen, beispielsweise Solarzellen, oder nach optoelektronischen Modulen oder Geräten wie beispielsweise Smartphones oder Tablet-Computern.

Die verwendeten Materialien müssen dabei eine gute elektrische Leitfähigkeit und vorzugsweise eine hohe optische Transparenz aufweisen. Vorteilhaft sind außerdem ein niedriger Preis, ein einfaches Auftragungsverfahren sowie eine geringe Toxizität.

Gängige Materialien mit breiter kommerzieller Anwendung sind Indium-dotiertes Zinn(IV)-Oxid (ITO) und Fluor-dotiertes Zinn(IV)-Oxid (FTO).

Die verwendeten Materialien werden in der Regel im Vakuum durch Sputtern aufgetragen. Dies führt zu exzellenten Leitfähigkeiten und hohen optischen Transparenzen.

Sputtern ist jedoch ein vergleichsweise aufwendiges Verfahren. Darüber hinaus können beispielsweise bei der Herstellung einer Fluor-dotierten Zinn(IV)-Oxid Beschichtung durch das eingesetzte Fluor toxische Nebenprodukte entstehen.

Die Verwendung von Indium-dotiertem Zinn(IV)-Oxid ist dagegen sehr kostenintensiv. Weitere aus dem Stand der Technik bekannte transparente, leitfähige Beschichtungen sind beispielsweise Antimon-dotiertes Zinn(IV)-Oxid (ATO) oder Wolfram-dotiertes Zinn(IV)-Oxid (TTO).

Die Nichtpatentliteratur Huang et al. (J. Sol-Gel Sci. Technol. 2010 (54), Seiten 276 bis 281) beschreibt transparente leitfähige Wolfram-dotierte Zinnoxidfilme, die durch Sol-Gel-Technik auf Quarzglassubstraten abgeschieden wurden.

Wie aus der Nichtpatentliteratur Huang et al. (2010), Seite 280 hervorgeht, hat die Konzentration der Wolfram-Dotierung einen unterdrückenden Effekt auf das Wachstum von polykristallinen Filmen.

Die Nichtpatentliteratur Huang (2009) Thin Solid Films, 2010 (518), Seiten 1892-1896) beschreibt amorphe Wolfram-dotierte Zinnoxidfilme und deren Herstellung.

Die chinesische Patentanmeldung CN 101413099 A beschreibt die Herstellung von polykristallinen Wolfram-dotierten Zinn(IV)-Oxidfilmen unter Verwendung von Puls-Plasma-Abscheidung (PPD: pulse plasma deposition), wobei Zinndioxid und metallisches Wolfram zerkleinert, gemischt, vorgeformt und durch Sintern in ein Block-förmiges Material überführt werden, das mittels Puls-Plasma-Abscheidung auf Quarzglassubstrate übertragen wird.

Das beschriebene Verfahren ist aufwendig. Beispielsweise wird das verwendete elementare Wolfram in Gegenwart von Zinn(IV)-oxid 12 h bei 800°C oxidiert und das erhaltene Mischoxid anschließend gemahlen, um eine homogene Durchmischung des Mischoxids zu erreichen. Das durchmischte Mischoxid-Pulver wird nachfolgend für 12 h bei 850°C gesintert, um ein PPD-Target zu erhalten, das mittels eines Plasmastrahls verdampft werden kann.

Huang et al., Thin Solid Films 518 (2010) 1892-1896 betrifft Untersuchungen von Wolfram-dotierten Zinnoxidfilmen im Hinblick auf strukturelle elektrische und optische Eigenschaften. US 2,692,836 betrifft ein Verfahren zur Erhöhung der elektrischen Leitfähigkeit von Zinnoxidfilmen. DE 37 42 373 A1 betrifft ein Verfahren zum Beschichten von Glas und beschichtetes Flachglas. Aufgabe der vorliegenden Erfindung ist es somit, ein Verfahren zum Herstellen einer elektrisch leitfähigen Beschichtung bereitzustellen, das leicht und kostengünstig anzuwenden ist und die Bereitstellung einer Beschichtung ermöglicht, die eine gute elektrische Leitfähigkeit aufweist.

Darüber hinaus soll die mit dem erfindungsgemäßen Verfahren hergestellte elektrisch leitfähige Beschichtung hoch temperaturbeständig und chemisch stabil gegen Korrosion sein.

Die Aufgabe der vorliegenden Erfindung wird gelöst durch die Bereitstellung eines Verfahrens zum Herstellen einer elektrisch leitfähigen Beschichtung gemäß Anspruch 1.

Bevorzugte Ausführungsformen des erfindungsgemäßen Verfahrens sind in den abhängigen Ansprüchen 2 bis 5 angegeben.

Das erfindungsgemäße Verfahren zum Herstellen einer elektrisch leitfähigen Beschichtung, die kristallines Wolfram-dotiertes Zinnoxid, vorzugsweise kristallines Wolfram-dotiertes Zinn(IV)-Oxid, umfasst oder daraus besteht, umfasst folgenden Schritt:
a) Sprühpyrolysieren einer Lösung, die in einem Lösungsmittel wenigstens eine lösliche Zinnverbindung und wenigstens eine lösliche Wolframverbindung enthält, in Gegenwart von Sauerstoff oder Sauerstoff-abgebender/en Verbindung(en) unter Erzeugung einer kristallines Wolfram-dotiertes Zinnoxid-haltigen Schicht, vorzugsweise einer kristallines Wolfram-dotiertes Zinn(IV)-Oxid-haltigen Schicht, wobei das Sprühpyrolysieren in Intervallen von 0,1 bis 10 Sekunden erfolgt und die elektrisch leitfähige Beschichtung eine Schichtdicke aus einem Bereich von 170 bis 5000 nm aufweist.

Die Erfinder haben überraschend festgestellt, dass sich mit dem erfindungsgemäßen Verfahren eine Wolfram-dotierte Zinnoxid-haltigen Schicht, vorzugsweise Wolfram-dotiertes Zinn(IV)-Oxid-haltige Schicht, abscheiden lässt, die im Wesentlichen kristallin, vorzugsweise kristallin, ist.

Eine elektrisch leitfähige Beschichtung, die vorzugsweise durch das erfindungsgemäße Verfahren hergestellt wurde, umfasst kristallines, Wolfram-dotiertes Zinnoxid, vorzugsweise Wolfram-dotiertes Zinn(IV)-Oxid. Vorzugsweise besteht die elektrisch leitfähige Beschichtung aus kristallinem Wolfram-dotierten Zinnoxid, vorzugsweise aus kristallinem Wolfram-dotierten Zinn(IV)-Oxid.

Die erfindungsgemäß hergestellte elektrische leitfähige Beschichtung weist eine Schichtdicke aus einem Bereich von 170 bis 5000 nm, vorzugsweise aus einem Bereich von 450 bis 3400 nm, vorzugsweise aus einem Bereich von 780 bis 2700 nm, weiter vorzugsweise aus einem Bereich von 1000 bis 2000 nm, auf.

Bei einer bevorzugten Ausführungsform des erfindungsgemäßen Verfahrens wird als Lösungsmittel ein organisches Lösungsmittel verwendet, wobei das organische Lösungsmittel vorzugsweise weniger als 15 Vol.-% Wasser, weiter vorzugsweise weniger als 9 Vol.-%, noch weiter vorzugsweise weniger als 5 Vol.-% Wasser, jeweils bezogen auf das Gesamtvolumen des Lösungsmittels, enthält.

Vorzugsweise sind geeignete organische Lösungsmittel aliphatische Alkohole, aliphatische Ether, aliphatische Ketone, aliphatische Aldehyde und Mischungen derselben.

Gemäß einer bevorzugten Variante werden als organische Lösungsmittel aliphatische Alkohole verwendet. Vorzugsweise handelt es sich bei den aliphatischen Alkoholen um Methanol, Ethanol oder Mischungen davon. Äußerst bevorzugt wird als organisches Lösungsmittel Ethanol verwendet.

Bei einer weiteren bevorzugten Variante des erfindungsgemäßen Verfahrens werden als Zinnverbindung, vorzugsweise Zinn(IV)-Verbindung, Zinnsalze, vorzugsweise Zinn(IV)-Salze, verwendet. Geeignete Zinnsalze, vorzugsweise Zinn(IV)-Salze, sind vorzugsweise in organischem Lösungsmittel lösliche Zinnsalze. Vorzugsweise sind die Zinnsalze, weiter bevorzugt Zinn(IV)-Salze, in aliphatischem Alkohol, vorzugsweise Methanol, Ethanol oder Mischungen davon löslich. Äußerst bevorzugt sind die Zinnsalze, weiter bevorzugt Zinn(IV)-Salze, in Ethanol löslich.

Bei dem vorzugsweise verwendeten Ethanol handelt es sich um technischen Ethanol mit einem Ethanolgehalt von etwa 96 bis 99 Vol.-%. Der Ethanol kann mithin Vergällungsmittel, beispielsweise Methylethylketon, und/oder Wasser in einer Menge von etwa 1 bis 4 Vol.-% enthalten. Selbstverständlich kann auch reiner und getrockneter Ethanol verwendet werden.

Geeignete Zinnsalze, vorzugsweise Zinn(IV)-Salze, umfassen beispielsweise Zinnhalogenide, vorzugsweise Zinn(IV)-halogenide, die aus der Gruppe, die aus Zinn(IV)-chlorid, Zinn(IV)-bromid, Zinn(IV)-jodid, Hydraten davon, Komplexen davon und Mischungen derselben besteht, ausgewählt werden. Weitere geeignete Zinnsalze, vorzugsweise Zinn(IV)-Salze, umfassen beispielsweise Zinn(IV)-sulfat, Zinn(IV)-nitrat, Hydrate davon, Komplexe davon oder Mischungen derselben.

Ein geeignetes Hydrat ist beispielsweise Zinn(IV)-chlorid-pentahydrat.

Geeignete Komplexe sind beispielsweise Hexachlorozinnsäure H₂[SnCl₆] oder Hexachlorozinnsäurehexahydrat H₂SnCl₆ x 6 H₂O oder Ammoniumhexachlorostannat (NH₄)₂[SnCl₆]).

Des Weiteren sind metallorganische Zinnverbindungen, vorzugsweise metallorganische Zinn(IV)verbindungen, sehr geeignet. Für die Zwecke der vorliegenden Erfindung geeignete metallorganische Zinnverbindungen sind beispielsweise Zinn(IV)-acetat, Zinn(IV)-bis(acetylacetonat)dichlorid, Zinn(IV)-bis(acetylacetonat)dibromid, Zinn(IV)-tert-butoxid, Tetrakis(dimethylamido)zinn(IV), Zinn(IV)isopropoxid, Mono-, Di-, Tri-, Tetrabutylzinn. Des Weiteren sind allgemein R₄Sn, R₃SnX, R₂SnX₂, RSnX₃, wobei vorzugsweise R unabhängig voneinander für einen Kohlenwasserstoffrest mit 1 bis 10, vorzugsweise 2 bis 6, Kohlenstoffatomen ist, für die Zwecke der Erfindung verwendbar. Vorzugsweise werden die Kohlenwasserstoffreste unabhängig voneinander aus der Gruppe ausgewählt, die aus Formyl-, Alkyl-, Aryl-, Allyl-, Vinyl-, Acetyl- und Acylrest besteht. X ist vorzugsweise Halogenid und/oder Hydroxyl. Wenn X Halogenid ist, wird X vorzugsweise aus der Gruppe, die aus Chlorid, Bromid, lodid und Mischungen davon besteht, ausgewählt.

Anstelle von metallorganischen Zinn(IV)Verbindungen können auch Zinn(II)verbindungen, beispielsweise Zinn(II)ethylhexanoat, verwendet werden.

Bei einer weiteren bevorzugten Ausführungsform werden als Wolframverbindungen, vorzugsweise Wolfram(VI)-Verbindungen, Wolframsalze, vorzugsweise Wolfram(VI)-Salze, verwendet.

Geeignete Wolframsalze, vorzugsweise Wolfram(VI)-Salze, sind beispielsweise Wolframhalogenide, vorzugsweise Wolfram(VI)-halogenide, die aus der Gruppe, die aus Wolfram(VI)chlorid, Wolfram(VI)bromid, Wolfram(VI)jodid und Mischungen davon besteht, ausgewählt werden. Weitere geeignete Wolframsalze, vorzugsweise Wolfram(VI)-Salze, umfassen beispielsweise Wolfram(VI)sulfat, Wolfram(VI)nitrat, Wolfram(VI)hexacarbonyl, Wolfram(VI)oxychlorid, Wolfram(VI)dichloridoxid, Bis(tert-butylimino)bis(dimethylamino)wolfram(VI) und/oder Wolfram(VI)ethoxid. Die vorgenannten Wolframsalze umfassen auch Komplexe und Hydrate.

Auch metallorganische Wolframverbindungen sind für die Zwecke der vorliegenden Erfindung sehr geeignet. Beispielsweise können Wolframoxo-alkoxide, vorzugsweise mit der chemischen Formel WO(OR)₄, wobei R unabhängig voneinander für einen Kohlenwasserstoffrest mit 1 bis 10 Kohlenstoffatomen, vorzugsweise 2 bis 6 Kohlenstoffatomen steht, verwendet werden. Bei dem Kohlenwasserstoffrest kann es sich beispielsweise um tert-Butyl-, iso-Propyl-, Alkyl-, OCH₂-tert-Butyl- oder Mischungen davon handeln. Weitere geeignete metallorganische Verbindungen sind beispielsweise Wolframoxo-alkoxid/β-Diketonverbindung(en), vorzugsweise mit der chemischen Formel WO(OR)₃ L, wobei R unabhängig voneinander für einen Kohlenwasserstoffrest mit 1 bis 10 Kohlenstoffatomen, vorzugsweise 2 bis 6 Kohlenstoffatomen, vorzugsweise für tert-Butyl- und/oder iso-Propyl- steht und wobei L vorzugsweise für eine β-Diketonverbindung, beispielsweise für Acetylacetonat, steht.

Geeignete Sauerstoff- oder gasförmige Sauerstoff-abgebende Verbindung(en) werden vorzugsweise aus der Gruppe, die aus Sauerstoff, Luft und Mischungen davon besteht, ausgewählt. Vorzugsweise wird Sauerstoff oder Luft verwendet. Im Hinblick auf die allgemeine Verfügbarkeit wird vorzugsweise Luft verwendet.

Bei einer bevorzugten Ausführungsform des erfindungsgemäßen Verfahrens wird das Sprühpyrolysieren in Gegenwart wenigstens eines, vorzugsweise inerten, Trägergases, das aus der Gruppe, die aus Helium, Neon, Argon, Stickstoff und Mischungen davon besteht, ausgewählt wird, durchgeführt. Bei dieser Vorgehensweise erfolgt das Sprühpyrolysieren in einer Sauerstoff-haltigen Atmosphäre, vorzugsweise Luft. Mithin kommt die zu versprühende Lösung mit den Zinn- und Wolframverbindungen bei dieser Verfahrensvariante erst im Moment des Sprühvorganges mit einer oder mehreren Sauerstoff abgebenden Komponenten, vorzugsweise Luft, in Kontakt.

Der Anteil an Sauerstoff oder gasförmiger/en Sauerstoff-abgebender/en Verbindung(en) liegt vorzugsweise in einem Bereich von 5 bis 30 Vol.-%, weiter bevorzugt von 18 bis 22 Vol.-%, jeweils bezogen auf das Gesamtvolumen von Trägergas und Sauerstoff oder gasförmiger Sauerstoff-abgebender Verbindung bzw. Sauerstoff-abgebenden Verbindungen. Der Anteil von Sauerstoff in der Luft liegt bei etwa 21 Vol.-%.

Das Sprühpyrolysieren erfolgt in Intervallen. Die Intervalle liegen dabei im Bereich von 0,1 bis 10 Sekunden, vorzugsweise von 0,5 bis 5 Sekunden, weiter bevorzugt von 0,8 bis 2 Sekunden. Als sehr geeignet hat sich ein Intervall von 1 Sekunde erwiesen.

Bei einer Sprühpyrolyse in Intervallen erfolgt der Sprühvorgang für den angegebenen Zeitraum. Der Zeitraum der Unterbrechung, d.h. der Zeitraum, in dem kein Sprühvorgang erfolgt, entspricht gemäß einer bevorzugten Variante, dem Zeitraum des Sprühvorganges.

Durch den Sprühvorgang, d.h. das Versprühen der zu verwendenden Lösung, kann es zu einer Abkühlung des, vorzugsweise erwärmten, Substrates kommen. In dem Zeitraum der Unterbrechung der Sprühpyrolyse kann das Substrat wieder erwärmt werden. Bei dem Substrat handelt es sich vorzugsweise um ein keramisches Substrat, vorzugsweise eine Grobkeramik, beispielsweise einen Dachziegel, Ziegel oder eine Fassadenwand. Vorzugsweise ist das Substrat ein Dachziegel.

Der Zeitraum der Unterbrechung kann auch kürzer oder länger als der Zeitraum des Sprühvorganges gewählt werden. Die Dauer der gewählten Unterbrechung hängt davon ab, wie stark das Substrat durch das Aufsprühen der Lösung abgekühlt, bzw. wie lange die Aufheizung des Substrates auf die gewünschte Temperatur dauert.

Als geeignet hat sich ein Sprühpyrolysieren erwiesen, das in einem Intervall von 1 s, gefolgt von einer Unterbrechung von 1 s, erfolgt. Diese Intervalle werden wiederholt, bis die gewünschte Schichtdicke aufgebracht ist, beispielsweise 10 bis 500 mal oder 15 bis 200 mal oder 20 bis 100 mal oder 25 bis 50 mal.

Die Substrattemperatur beträgt vorzugsweise wenigstens 400°C, weiter bevorzugt wenigstens 450°C. Vorzugsweise liegt die Substrattemperatur in einem Bereich von 400°C bis 1300°C, weiter bevorzugt von 450°C bis 1000°C, noch weiter bevorzugt von 500 bis 750°C, noch weiter bevorzugt von 550°C bis 700°C.

Die Aufheizung des Substrates kann mit den üblichen technischen Mitteln erfolgen, beispielsweise durch Widerstandsheizung und/oder durch Einstrahlung von IR-Strahlung.

Bei einer weiteren bevorzugten Variante der Erfindung weisen das Substrat und die aufgebrachte elektrisch leitfähige Beschichtung einen sehr ähnlichen, vorzugsweise nahezu identischen, Wärmeausdehnungskoeffizienten auf. Gemäß einer bevorzugten Weiterbildung der Erfindung liegt die prozentuale Abweichung bei dem Wärmeausdehnungskoeffizienten der erfindungsgemäß hergestellten Beschichtung, bezogen auf den Wärmeausdehnungskoeffizienten des Substrates, bei weniger als 10%, vorzugsweise bei weniger als 7%, noch weiter vorzugsweise bei weniger als 5%, noch weiter vorzugsweise bei 0%. Insbesondere bei einem Keramiksubstrat, beispielsweise einem Dachziegel, ist es wesentlich, dass bei Sonneneinstrahlung keine Beschädigungen aufgrund thermischer Spannungen auftreten. Beispielsweise können sich Dachziegel im Hochsommer auf einem Dach auf Temperaturen von bis zu 60 °C oder 70°C aufwärmen bzw. im Winter beispielsweise auf -25°C bis -35°C abkühlen.

Bei einer bevorzugten Ausführungsform des erfindungsgemäßen Verfahrens wird während der Sprühpyrolyse Ultraschall eingestrahlt.

Bei dem erfindungsgemäßen Verfahren wird die auf das Substrat aufzubringende Lösung, die wenigstens eine lösliche Zinnverbindung und wenigstens eine lösliche Wolframverbindung enthält, vorzugsweise in Tropfenform auf das zu beschichtende Substrat aufgebracht. Das Überführen der Lösung in Tropfenform kann durch Versprühen mit Druckgas, beispielsweise Druckluft, erfolgen.

Bei Einstrahlung von Ultraschall während der Sprühpyrolyse kann der Anteil an Druckgas, beispielsweise Druckluft, mit dem die Lösung, die wenigstens eine lösliche Zinnverbindung und wenigstens eine lösliche Wolframverbindung enthält, versprüht wird, verringert werden.

Gemäß einer bevorzugten Variante der Erfindung wird auf Druckgas, beispielsweise Druckluft, vollständig verzichtet. Bei dieser Verfahrensvariante wird die aufzubringende Lösung durch Einstrahlung von Ultraschall in die Tropfenform überführt. Bei dieser Verfahrensvariante kann die Tropfenbildung mithin durch Kaltvernebelung erfolgen.

Durch eine Verringerung von Druckgas, vorzugsweise Druckluft, während des Beschichtungsvorganges erfolgt die Abkühlung der Oberfläche des zu beschichtenden Substrats weniger stark. Das Druckgas, vorzugsweise die Druckluft, bewirkt neben den auf die erwärmte Substratoberfläche auftretenden Flüssigkeitstropfen eine nicht unwesentliche Abkühlung der Substratoberfläche. Insoweit erfolgt bei einer bevorzugten Verfahrensvariante die Aufbringung der Lösung, die wenigstens eine lösliche Zinnverbindung und wenigstens eine lösliche Wolframverbindung enthält, ausschließlich mittels Ultraschall. Bei dieser Verfahrensvariante wird die zu beschichtende Substratoberfläche am geringsten durch den Sprüh- bzw. Beschichtungsvorgang abgekühlt. Somit können vorzugsweise bei dem oben genannten Aufsprühen bzw. Beschichten in Intervallen die Heizintervalle zur erneuten Aufheizung der Substratoberfläche zeitlich verkürzt werden.

Ein weiterer wesentlicher Vorteil bei der zusätzlichen oder ausschließlichen Verwendung von Ultraschall ist, dass die Tropfengröße der aufzubringenden Lösung definiert eingestellt werden kann. Über die Tropfengröße kann die elektrisch leitfähige Beschichtung kontrolliert aufgebracht werden. Beispielsweise kann die Schichtdicke der elektrisch leitfähigen Beschichtung kontrolliert eingestellt werden

Die Tropfengröße bzw. der Tropfendurchmesser liegt bei Einstrahlung von Ultraschall vorzugsweise in einem Bereich von 26 bis 19 µm, weiter bevorzugt von 24 bis 21 µm, noch weiter bevorzugt von 23 bis 22 µm.

Der eingestrahlte Ultraschall liegt vorzugsweise in einem Bereich von 40 bis 60 kHz, weiter bevorzugt von 45 bis 55 kHz, noch weiter bevorzugt von 50 bis 51 kHz.

Vorzugsweise wird das Sprühpyrolysieren bei einem Druck aus einem Bereich von 0,1 bar bis 1 bar, weiter bevorzugt von 0,20 bar bis 0,80 bar, durchgeführt. Als sehr geeignet hat sich ein Bereich von 0,30 bar bis 0,70bar erwiesen. Vorzugsweise erfolgt das Sprühpyrolysieren bei einem Druck von etwa 0,5 bar. Bei diesem Druck handelt es sich um den Sprühdruck, mit dem die zu verwendende Lösung versprüht wird. Vorzugsweise wird das Sprühpyrolysieren für einen Zeitraum von 1 s bis 1 h, weiter bevorzugt von 10 s bis 30 Minuten, weiter bevorzugt von 15 s bis 15 Minuten, noch weiter bevorzugt von 20 s bis 5 Minuten, noch weiter bevorzugt von 20 s bis 1 Minute, durchgeführt.

Die Erfinder haben festgestellt, dass sich die Schichtdicke der mit dem erfindungsgemäßen Verfahren hergestellten elektrisch leitfähigen Beschichtung in einfacher Weise durch Variation des Drucks und/oder der eingestrahlten Frequenz des Ultraschalls und/oder der Beschichtungsdauer einstellen lässt.

Das erfindungsgemäße Verfahren kann in apparativer Hinsicht in sehr einfacher Form durchgeführt werden. So kann die Lösung, die in einem Lösungsmittel wenigstens eine lösliche Zinnverbindung und wenigstens eine lösliche Wolframverbindung enthält, über einen herkömmlichen Ultraschallzerstäuber auf das vorzugsweise erhitzte Substrat aufgebracht werden. Die zu versprühende Lösung wird vorzugsweise einem Vorratsbehälter vorzugsweise unter Verwendung einer Pumpe entnommen und dem Ultraschallzerstäuber zugeführt.

Das Substrat kann dabei beispielsweise auf einer Heizplatte angeordnet und von der der zu beschichtenden Oberfläche des Substrates abgewandten Oberfläche beheizt sein. Der Ultraschallzerstäuber kann über der zu beschichtenden Oberfläche in einer Sauerstoffatmosphäre, vorzugsweise Luft, in der X- und Y-Ebene verfahrbar angeordnet sein. Der Abstand (Z-Achse) zwischen Ultraschallzerstäuber ist variabel einstellbar. Durch, optional mehrfaches, "Abfahren" der zu beschichtenden Oberfläche mit dem Ultraschallzerstäuber kann die zu versprühende Lösung aufgebracht werden, bis eine gewünschte Schichtdicke oder gewünschte elektrische Leitfähigkeit eingestellt ist. Bei dieser apparativen Ausgestaltung wird der Sauerstoff über die Umgebungsluft zugeführt. Alternativ kann selbstverständlich die auf die Substratoberfläche aufzubringende Lösung unter Verwendung von Druckgas, beispielsweise Druckluft, über eine herkömmliche Sprühdüse aufgebracht werden.

Mit dem erfindungsgemäßen Verfahren wird eine elektrisch leitfähige Beschichtung in einer Schichtdicke aus einem Bereich von 170 nm bis 5000 nm, vorzugsweise 450 bis 3400 nm, vorzugsweise 780 bis 2700 nm, vorzugsweise 1000 bis 2000 nm, hergestellt.

Die Erfinder haben weiterhin festgestellt, dass die, vorzugsweise mit dem erfindungsgemäßen Verfahren hergestellte, elektrisch leitfähige Beschichtung umfassend kristallines Wolfram-dotiertes Zinnoxid, vorzugsweise Wolfram-dotiertes Zinn(IV)-Oxid, eine hohe mechanische Stabilität aufweist. Durch die hohe mechanische Stabilität wird beispielsweise ein Ablösen der elektrisch leitfähigen Beschichtung bei einer weiteren Verarbeitung oder Bearbeitung, beispielsweise einer nachfolgenden Beschichtung, verhindert. Weiterhin zeigt die elektrisch leitfähige Beschichtung einen geringen Abrieb bei mechanischer Beanspruchung.

Bei einer weiteren bevorzugten Variante des erfindungsgemäßen Verfahrens enthält die Lösung, die in einem Lösungsmittel wenigstens eine lösliche Zinnverbindung, vorzugsweise Zinn(IV)-Verbindung, und wenigstens eine lösliche Wolframverbindung vorzugsweise Wolfram(VI)-Verbindung, Wolfram in einem Anteil von 0,1 bis 20 Molprozent, vorzugsweise 1 bis 5 Molprozent, weiter vorzugsweise 2 bis 4 Molprozent, jeweils bezogen auf die Gesamtstoffmenge an Wolfram und Zinn.

Durch Verwendung einer Lösung, die in einem Lösungsmittel wenigstens eine lösliche Zinnverbindung, vorzugsweise Zinn(IV)-Verbindung, und wenigstens eine lösliche Wolframverbindung, vorzugsweise Wolfram(VI)-Verbindung, Wolfram in einem Anteil von 0,1 bis 20 Molprozent, vorzugsweise 1 bis 5 Molprozent, jeweils bezogen auf die Gesamtstoffmenge an Wolfram und Zinn, enthält, kann mit dem erfindungsgemäßen Verfahren in einfacher und kostengünstiger Weise die erfindungsgemäß hergestellte elektrisch leitfähige Beschichtung hergestellt werden, die kristallines Wolfram-dotiertes Zinnoxid, vorzugsweise Wolfram-dotiertes Zinn(IV)-Oxid, umfasst oder daraus besteht, wobei vorzugsweise das kristalline Wolfram-dotierte Zinnoxid Wolfram in einem Anteil von 0,1 bis 20 Molprozent, vorzugsweise 1 bis 5 Molprozent, weiter vorzugsweise 2 bis 4 Molprozent, jeweils bezogen auf die Gesamtstoffmenge an Wolfram und Zinn des Wolfram-dotierten Zinnoxids, enthält.

Die erfindungsgemäß hergestellte Wolfram-dotierte Zinnoxidschicht ist eine Schicht, die im Wesentlichen kristallines, vorzugsweise kristallines, Wolfram-dotiertes Zinnoxid, vorzugsweise Wolfram-dotiertes Zinn(IV)-Oxid, enthält oder daraus besteht.

Weiter bevorzugt ist die erfindungsgemäß hergestellte Schicht mit oder aus Wolfram-dotiertem Zinnoxid, vorzugsweise Wolfram-dotiertem Zinn(IV)-Oxid, eine polykristalline Schicht, die aus vielen kleinen Einzelkristallen, die auch als Kristallite bezeichnet werden können, aufgebaut. Benachbarte Kristallite der polykristallinen Schicht können sich in der Orientierung ihres Kristallgitters unterscheiden.

Vorzugsweise weist die erfindungsgemäß hergestellte Wolfram-dotiertes Zinnoxid-haltige Schicht, vorzugsweise Wolfram-dotiertes Zinn(IV)-Oxid-haltige Schicht, kolumnare Kristallite auf, die eine säulenartige Struktur aufweisen, die weiter bevorzugt in gleicher Richtung, d.h. im Wesentlichen parallel zueinander, ausgerichtet ist. Vorzugsweise werden die Kristallite durch ein kolumnares Schichtwachstum während der Herstellung gebildet. Gemäß einer bevorzugten Variante der Erfindung umfasst die erfindungsgemäß hergestellte elektrisch leitfähige Schicht kolumnares Wolfram-dotiertes Zinnoxid, vorzugsweise Wolfram-dotiertes Zinn(IV)-Oxid, oder besteht daraus.

Die Erfinder haben festgestellt, dass durch Aufbau der erfindungsgemäß hergestellten kristallinen, vorzugsweise polykristallinen, Wolfram-dotiertes Zinnoxid-haltigen Schicht aus kolumnaren Kristalliten eine homogene Wolfram-dotiertes Zinnoxid-haltige Schicht erhalten wird. Vorzugsweise ist die aus kolumnaren Kristalliten aufgebaute homogene Wolfram-dotierte Zinnoxid-haltige Schicht eine durchgehende Schicht, bei der sich die kolumnaren Kristallite im Wesentlichen über die gesamte Schichtdicke erstrecken.

Vorzugsweise weist die erfindungsgemäß hergestellte elektrisch leitfähige Beschichtung einen Anteil an kristallinem Wolfram-dotierten Zinnoxid, vorzugsweise kristallinem Wolfram-dotierten Zinn(IV)-Oxid, in einem Bereich von 50 bis 100 Gew.-%, vorzugsweise aus einem Bereich 75 bis 98 Gew.-%, jeweils bezogen auf das Gesamtgewicht der elektrisch leitfähigen Beschichtung, auf.

Weiter bevorzugt weist die erfindungsgemäß hergestellte elektrisch leitfähige Beschichtung einen Anteil an amorphem Wolfram-dotierten Zinnoxid von weniger als 10 Gew.-%, vorzugsweise weniger als 2 Gew.-%, jeweils bezogen auf das Gesamtgewicht der Beschichtung, weiter vorzugsweise kein amorphes Wolfram-dotiertes Zinnoxid, auf.

Die Erfinder haben festgestellt, dass mit dem erfindungsgemäßen Verfahren eine elektrisch leitfähige Beschichtung bereitgestellt werden kann, die einen sehr geringen

Anteil an amorphem Wolfram-dotierten Zinnoxid und vorzugsweise kein amorphes Wolfram-dotiertes Zinnoxid aufweist.

Die Erfinder haben weiterhin festgestellt, dass bei einem Anteil an amorphem Wolfram-dotierten Zinnoxid von weniger als 10 Gew.-%, weiter vorzugsweise von weniger als 2 Gew.-%, vorzugsweise bei Abwesenheit von amorphem Wolfram-dotierten Zinnoxid, jeweils bezogen auf das Gesamtgewicht der elektrisch leitfähigen Beschichtung, in der erfindungsgemäß hergestellten elektrisch leitfähigen Beschichtung die Anzahl von Defekten in der Kristallstruktur der in der Beschichtung enthaltenen Kristallite verringert wird. Defekte in der Kristallstruktur der Kristallite sind beispielsweise das Auftreten von Leerstellen, d.h. freie Gitterplätze, die im regulären Kristallgitter besetzt sind, oder das Auftreten von Zwischengitteratomen, die auf Plätzen sitzen, die im regulären Kristallgitter unbesetzt sind.

Durch eine geringe Anzahl von Defekten in der Kristallstruktur der in der Beschichtung enthaltenen Kristallite ist der elektrische Widerstand der erfindungsgemäß hergestellten elektrisch leitfähigen Schicht gering.

Weiterhin wird bei einem Anteil an amorphem Wolfram-dotierten Zinnoxid von weniger als 10 Gew.-%, weiter vorzugsweise von weniger als 2 Gew.-%, vorzugsweise bei Abwesenheit von amorphem Wolfram-dotierten Zinnoxid, in der erfindungsgemäß hergestellten elektrisch leitfähigen Beschichtung das Auftreten von Fremdphasen in der Beschichtung, beispielsweise in Form von Einschlüssen, Ausscheidungen oder Hohlräumen, verringert. Das Vorhandensein von Fremdphasen in der erfindungsgemäß hergestellten elektrisch leitfähigen Beschichtung kann beispielsweise bei mechanischer oder thermischer Belastung der Beschichtung zu mechanischen Spannungen innerhalb der Beschichtung führen. Mechanische Spannungen innerhalb der Beschichtung können zu einem teilweisen oder vollständigen Ablösen der Beschichtung oder dem Auftreten von Rissen führen. Diese führen nachteiligerweise zu einer Verschlechterung der elektrischen Leitfähigkeit.

Bei einer weiteren bevorzugten Variante weist die erfindungsgemäß hergestellte elektrisch leitfähige Beschichtung einen spezifischen Widerstand von weniger als etwa 7,0 x 10⁻³ Ohm x cm, vorzugsweise von weniger als etwa 5,0 x 10⁻³ Ohm x cm, weiter vorzugsweise von weniger als etwa 4,0 x 10⁻³ Ohm x cm, weiter vorzugsweise von weniger als etwa 3,5 x 10⁻³ Ohm x cm, weiter vorzugsweise von etwa 3,0 x 10⁻³ Ohm x cm, auf.

Der spezifische Widerstand der erfindungsgemäß aufgebrachten elektrisch leitfähigen Schicht liegt vorzugsweise in einem Bereich von etwa 7 x 10⁻³ Ohm x cm bis etwa 2,9 x 10⁻³ Ohm x cm, weiter vorzugsweise von etwa 5 x 10⁻³ Ohm x cm bis etwa 3,1 x 10⁻³ Ohm x cm, noch weiter vorzugsweise von etwa 4 x 10⁻³ Ohm x cm bis etwa 3,2 x 10⁻³ Ohm x cm, noch weiter vorzugsweise von etwa 3,8 x 10⁻³ Ohm x cm bis etwa 3,3 x 10⁻³ Ohm x cm.

Vorzugsweise liegt der spezifische Widerstand bei einer Schichtdicke von 170 bis 450 nm in einem Bereich von etwa 7 x 10⁻³ Ohm x cm bis etwa 4,2 x 10⁻³ Ohm x cm.

Weiter vorzugsweise liegt der spezifische Widerstand bei einer Schichtdicke von 450 bis 780 nm in einem Bereich von etwa 4,2 x 10⁻³ Ohm x cm bis etwa 3,8 x 10⁻³ Ohm x cm.

Weiter vorzugsweise liegt der spezifische Widerstand bei einer Schichtdicke von 780 bis 1000 nm bei etwa 4,0 x 10⁻³ Ohm x cm bis 3,8 x 10⁻³ Ohm x cm.

Weiter vorzugsweise liegt der spezifische Widerstand bei einer Schichtdicke von 1000 bis 2000 nm in einem Bereich von etwa 3,8 x 10⁻³ Ohm x cm bis etwa 3,1 x 10⁻³ Ohm x cm.

Weiter vorzugsweise liegt der spezifische Widerstand bei einer Schichtdicke von 2000 bis 5000 nm in einem Bereich von etwa 3,1 x 10⁻³ Ohm x cm bis etwa 3,0 x 10⁻³ Ohm x cm.

Vorzugsweise ist die elektrisch leitfähige Beschichtung eine durchgehende Schicht. Unter dem Begriff "durchgehende Schicht" wird eine Beschichtung verstanden, die keine Unterbrechungen aufweist.

Weiter bevorzugt ist die erfindungsgemäß hergestellte kristallines Wolfram-dotiertes Zinnoxid-haltige Schicht, vorzugsweise Wolfram-dotiertes Zinn(IV)-Oxid-haltige Schicht, eine durchgehende Schicht, die keine Bindemittel enthält. Unter dem Begriff "Bindemittel" werden vorzugsweise Stoffe verstanden, die gleich- oder verschiedenartige Stoffe insbesondere stoffschlüssig miteinander verbinden.

Beispielsweise umfasst eine erfindungsgemäß hergestellte kristalline Wolfram-dotiertes Zinnoxid-haltige Schicht, vorzugsweise kristallines Wolfram-dotiertes Zinn(IV)-Oxid-haltige Schicht, keine Wolfram-dotierten Zinnoxidpartikel, die in einer Bindemittelphase, beispielsweise Lackschicht oder Silikatschicht, eingebettet sind.

Bei einer bevorzugten Ausführungsform wird die erfindungsgemäß hergestellte elektrisch leitfähige Beschichtung auf einem Substrat, vorzugsweise anorganischen oder organischen Substrat, angeordnet.

Vorzugsweise ist die elektrisch leitfähige Beschichtung vollflächig auf das Substrat, aufgebracht.

Die Erfinder haben festgestellt, dass sich mit dem erfindungsgemäßen Verfahren in einfacher und kostengünstiger Weise auch größere Substrate, wie beispielsweise ein Dachziegel, eine Fassadenplatte oder eine Fassadenwand, gleichmäßig mit einer erfindungsgemäß hergestellten Wolfram-dotierten Zinnoxidschicht, vorzugsweise Wolfram-dotierten Zinn(IV)-Oxidschicht, beschichten lassen.

Vorzugsweise ist das anorganische Substrat ein keramisches Substrat, vorzugsweise ein grobkeramisches Substrat, oder ein Glassubstrat.

Weiter bevorzugt ist ein keramisches Substrat oder Glassubstrat ein Fassadenelement oder ein Ziegel, vorzugsweise ein Dachziegel.

Weiter bevorzugt ist ein Ziegel, ein Dachziegel, ein Mauerziegel, ein Klinker, oder ein Vormauerstein.

Weiter bevorzugt ist ein Fassadenelement, eine Fassadenplatte oder eine Fassadenwand.

Vorzugsweise ist das organische Substrat, ein polymeres organisches Substrat, das einen Schmelzpunkt oder eine Glasübergangstemperatur von mehr als 300°C, vorzugsweise mehr als 350°C, aufweist.

Geeignete Polymere umfassen beispielsweise Polybenzimidazole oder Polyimide.

Geeignete Polymere sind beispielsweise kommerziell von der Fa. DuPont de Nemours (Neu-Isenburg, Deutschland) unter dem Handelsnamen Kapton® erhältlich. Geeignete Polybenzimidazole sind beispielsweise kommerziell erhältlich von der Fa. Performance Products Inc. (Charlotte, USA) unter dem Handelsnahmen Celazole (PBI) oder von der Fa. Quadrant AG (Zürich, Schweiz) unter dem Handelsnamen Duratron® PBI.

Bei einer weiteren bevorzugten Ausführungsform des Substrates ist zwischen der elektrisch leitfähigen Beschichtung und dem Substrat wenigstens eine Schutzschicht angeordnet.

Als Schutzschicht können beispielsweise elektrisch schwach- oder nichtleitende Materialien verwendet werden. Beispielsweise kann die wenigstens eine Schutzschicht als Isolatorschicht ausgebildet sein, die vorzugsweise ein dielektrisches Material enthält oder daraus besteht.

Geeignete Materialien für die Schutzschicht sind beispielsweise nichtmetallische anorganische Oxide, Porzellan, Glas, oder Kunststoff.

Vorzugsweise wird bei dem erfindungsgemäßen Verfahren zunächst die wenigstens eine Schutzschicht auf dem Substrat aufgebracht und nachfolgend die elektrisch leitfähige Beschichtung auf der wenigstens einen Schutzschicht angeordnet.

Geeignete Verfahren zum Aufbringen der wenigstens einen Schutzschicht sind aus dem Stand der Technik bekannt. Beispielsweise kann die wenigstens eine Schutzschicht durch Gießen, Streichen, Sprühen, Schleudern oder ähnlichen Verfahren auf das Substrat aufgebracht werden, wobei vorzugsweise die wenigstens eine Schutzschicht anschließend getrocknet und/oder gebrannt wird.

Alternativ kann die wenigstens eine Schutzschicht durch Kleben und/oder Laminieren auf dem Substrat angeordnet werden oder sein.

Bei einer weiteren bevorzugten Ausführungsform der Erfindung ist auf der elektrisch leitfähigen Beschichtung in elektrisch leitfähiger Verbindung wenigstens ein Photovoltaikmodul oder Optoelektronikmodul angeordnet oder anordnungsfähig.

Vorzugsweise ist das wenigstens eine Photovoltaikmodul oder Optoelektronikmodul mit der elektrisch leitfähigen Beschichtung verbindbar oder verbunden angeordnet.

Vorzugsweise ist das wenigstens eine Optoelektronikmodul ein Touch Panel, ein LCD-Display, ein optischer Sensor oder eine Leuchtdiode.

Bei einer bevorzugten Ausführungsform ist das wenigstens eine Photovoltaikmodul eine Solarzelle, vorzugsweise organische Farbstoffzelle. Eine organische Farbstoffzelle, beispielsweise eine Grätzelzelle, zeichnet sich dadurch aus, dass auch bei diffusem Licht Strom effektiv erzeugt wird. Mithin erfordert eine Farbstoffzelle im Unterschied zu einer Silizium-Solarzelle keine direkte Sonneneinstrahlung. Auch bei einem bewölkten Himmel, beispielsweise im Winter, erzeugt eine Farbstoffzelle sehr effektiv Strom.

Bei einer weiteren Ausgestaltung der Erfindung ist auf der erfindungsgemäß hergestellten elektrisch leitfähigen Beschichtung zunächst wenigstens eine Platin-haltige oder Platin-Schicht angeordnet. Bei noch einer weiteren Ausgestaltung ist auf der erfindungsgemäß hergestellten elektrisch leitfähigen Beschichtung zunächst wenigstens eine Graphit-haltige oder Graphit-Schicht angeordnet.

Bei der "Graphit" der Graphit-haltigen Schicht oder der Graphitschicht kann es sich im Sinne der vorliegenden Erfindung um einfachen Graphit, Ruß, Fullerene und/oder Kohlenstoffnanoröhrchen (carbon nano tubes (CNT)) handeln. Die Kohlenstoffnanoröhrchen können dabei einzelwandige Kohlenstoffnanoröhrchen, sogenannte single wall CNTs, oder mehrwandige Kohlenstoffnanoröhrchen, sogenannte multi wall CNTs, sein.

Auf der wenigstens einen Platin-haltigen oder Platin-Schicht bzw. Graphit-haltigen oder Graphit-Schicht ist gemäß einer weiteren Ausführungsform vorzugsweise wenigstens eine Elektrolytschicht angeordnet. Geeignete Materialien für die wenigstens eine Elektrolytschicht sind aus dem Stand der Technik bekannt und umfassen beispielsweise lodid, Bromid, Hydrochinon oder andere Redox-Systeme, wie beispielsweise Co(II)/Co(III)-Redoxsysteme.

Vorzugsweise ist auf der wenigstens einen Elektrolytschicht wenigstens eine poröse Schicht, die wenigstens einen Metalloxid-Halbleiter und wenigstens einen lichtempfindlichen Farbstoff umfasst, angeordnet. Unter einem "lichtempfindlichen Farbstoff" wird im Sinne der Erfindung ein Farbstoff verstanden, der durch Umgebungslicht in einen angeregten Zustand versetzt wird. Das angeregte Farbstoffmolekül überträgt Elektronen an den Metalloxidhalbleiter, vorzugsweise Titanoxid, weiter vorzugsweise TiO₂.

Geeignete Metalloxid-Halbleiter sind aus dem Stand der Technik bekannt und umfassen beispielsweise Oxide der Übergangsmetalle sowie Oxide der Elemente der dritten Hauptgruppe und der vierten, fünften und sechsten Nebengruppe des Periodensystems der Elemente. Bevorzugte Metalloxid-Halbleiter umfassen Oxide von Titan, Zirkon, Hafnium, Strontium, Zink, Indium, Yttrium, Lanthan, Vanadium, Niob, Tantal, Chrom, Molybdän, Wolfram, Zink, Eisen, Nickel oder Silber, Mischoxide oder Oxidgemische dieser Metalle. Gemäß einer bevorzugten Variante der Erfindung wird Titanoxid, vorzugsweise Titandioxid, als Metalloxid-Halbleiter verwendet. Das Titandioxid liegt vorzugsweise in der Kristallstruktur Anatas vor.

Geeignete lichtempfindliche Farbstoffe sind aus dem Stand der Technik bekannt und umfassen beispielsweise Cis-bis(isothiocyanato)bis(2,2'-bipyridyl-4,4'-dicarboxylato Ruthenium(II) (wird auch als "N3" bezeichnet), Di-tetrabutylammonium-cis-bis(isothiocyanato)bis(2,2'-bipyridyl-4,4'-dicarboxylato)Ruthenium(II) (wird auch als "N719" bezeichnet) und/oder Tris(cyanato)-2,2',2"-terpyridyl-4,4',4"-tricarboxylat)Ruthenium(II) (wird auch als "black dye" bezeichnet) oder Mischungen davon.

Des Weiteren sind dem Fachmann verwendbare lichtempfindliche Farbstoffe aus EP 0525 070 B2 oder der EP 0333 641 A1 bekannt.

Vorzugsweise wird oder ist auf der wenigstens einen porösen Schicht, die wenigstens einen Metalloxid-Halbleiter und wenigstens einen lichtempfindlichen Farbstoff umfasst, eine transparente, leitfähige Elektrode angeordnet, wobei die transparente, leitfähige Elektrode vorzugsweise eine transparente, leitfähige Beschichtung und ein transparentes Substrat aufweist, wobei die transparente, leitfähige Beschichtung die wenigstens eine poröse Schicht kontaktiert.

Geeignete transparente, leitfähige Elektroden sind aus dem Stand der Technik bekannt und umfassen beispielsweise Indiumzinn(IV)oxid beschichtetes Glas, Fluor-dotiertes Zinn(IV)-Oxid beschichtetes Glas, Antimon-dotiertes Zinn(IV)-Oxid oder ein Glassubstrat, das mit einer erfindungsgemäß hergestellten Wolfram-dotierten Zinnoxidschicht, vorzugsweise Wolfram-dotierten Zinn(IV)-Oxidschicht, beschichtet ist.

Vorzugsweise werden oder sind die Komponenten des wenigstens einen Photovoltaikmoduls auf der elektrisch leitfähigen Beschichtung angeordnet. Die Komponenten des wenigstens einen Photovoltaikmoduls, vorzugsweise der wenigstens einen Farbstoffzelle, können als fertiges Schichtpaket, das die wenigstens eine Platin-haltige oder Platin-Schicht bzw. Graphit-haltige oder Graphit-Schicht, die wenigstens eine Elektrolytschicht und die wenigstens eine poröse Schicht und optional eine transparente, leitfähige Elektrode umfasst, auf der elektrisch leitfähigen Beschichtung angeordnet werden oder sein.

Alternativ können die Komponenten des wenigstens einen Photovoltaikmoduls nacheinander als einzelne Schichten auf der elektrisch leitfähigen Beschichtung angeordnet werden oder sein.

Beispielsweise wird oder ist auf der erfindungsgemäß hergestellten elektrisch leitfähigen Beschichtung zunächst wenigstens eine Platin-haltige oder Platin-Schicht bzw. Graphit-haltige oder Graphitschicht 4 angeordnet.

Geeignete Verfahren zum Aufbringen der wenigstens einen Platin-haltigen oder Platin-Schicht bzw. Graphit-haltige oder Graphitschicht 4 sind aus dem Stand der Technik bekannt. Die Platin- oder Platin-haltige Schicht kann beispielsweise Gasphasenabscheidung oder Flammenpyrolyse aufgebracht werden oder sein. Die Graphit-haltige oder Graphitschicht kann beispielsweise durch Tauch-, Sprüh- und Drehbeschichtung, Siebdruck oder auch durch Gasphasenabscheidung, wie z.B. chemische Dampfabscheidung aufgebracht werden oder sein.

Auf der wenigstens einen Platin-haltigen oder Platin-Schicht bzw. Graphit-haltigen oder Graphit-Schicht wird oder ist vorzugsweise die wenigstens eine Elektrolytschicht angeordnet. Anschließend wird oder ist auf der wenigstens einen Elektrolytschicht die wenigstens eine poröse Schicht, die wenigstens einen Metalloxid-Halbleiter, vorzugsweise Titanoxid, vorzugsweise Titandioxid, und wenigstens einen lichtempfindlichen Farbstoff umfasst, angeordnet.

Verfahren zum Herstellen wenigstens einer Elektrolytschicht und der wenigstens einen porösen Schicht, die wenigstens ein Metalloxid-Halbleiter, vorzugsweise Titanoxid, vorzugsweise Titandioxid, und wenigstens ein lichtempfindlichen Farbstoff umfasst, sind aus dem Stand der Technik bekannt und werden beispielsweise in EP 0333641 A1 beschrieben. Vorzugsweise wird oder ist nachfolgend auf der wenigstens einen porösen Schicht eine transparente, leitfähige Elektrode angeordnet, wobei die transparente, leitfähige Elektrode vorzugsweise eine transparente, leitfähige Beschichtung und ein transparentes Substrat aufweist und die transparente, leitfähige Beschichtung die wenigstens eine poröse Schicht kontaktiert.

Weiter bevorzugt ist die transparente, leitfähige Elektrode ein Glassubstrat, das mit einer erfindungsgemäß hergestellten kristallines Wolfram-dotiertes Zinnoxid-haltigen Schicht, vorzugsweise kristallines Wolfram-dotiertes Zinn(IV)-Oxid-haltigen Schicht, beschichtet ist, wobei die Wolfram-dotierte Zinnoxidschicht vorzugsweise mit dem erfindungsgemäßen Verfahren hergestellt ist.

Bei einer alternativen Ausführungsform der Erfindung ist vorzugsweise zunächst auf ein transparentes Glassubstrat eine kristallines Wolfram-dotiertes Zinnoxid-haltige Schicht, vorzugsweise kristallines Wolfram-dotiertes Zinn(IV)-Oxid-haltige Schicht, vorzugsweise mit dem erfindungsgemäßen, Verfahren aufgebracht. Anschließend wird oder ist vorzugsweise auf die kristalline Wolfram-dotiertes Zinnoxid-haltige Schicht die wenigstens eine poröse Schicht, die vorzugsweise Metalloxidhalbleiter enthält oder daraus besteht, aufgebracht. Bei dem Metalloxidhalbleiter handelt es sich vorzugsweise um Titanoxid, vorzugsweise Titandioxid, das vorzugsweise in der Kristallstruktur Anatas vorliegt. Die poröse Schicht enthält ferner wenigstens einen lichtempfindlichen Farbstoff. Nachfolgend wird oder ist vorzugsweise auf der wenigstens einen porösen Schicht die wenigstens eine Elektrolytschicht angeordnet. Auf der Elektrolytschicht wird oder ist vorzugsweise ein Schichtpaket umfassend eine, vorzugsweise mit dem erfindungsgemäßen Verfahren hergestellte, elektrisch leitfähige Beschichtung und wenigstens eine Platin-haltige oder Platin-Schicht bzw. Graphit-haltige oder Graphit-Schicht angeordnet, wobei die wenigstens eine Platin-haltige oder Platin-Schicht bzw. Graphit-haltige oder Graphit-Schicht die Elektrolytschicht kontaktiert.

Bei einer bevorzugten Ausführungsform werden oder sind die Bestandteile der organischen Farbstoffzelle und die erfindungsgemäß hergestellte elektrisch leitfähige Beschichtung versiegelt. Eine langzeitstabile Versiegelung kann vorzugsweise durch Aufbringen von Epoxidharzkleber oder Glaslot erfolgen. Die Versiegelung verhindert beispielsweise, dass der Elektrolyt oder der lichtempfindliche Farbstoff aus der organischen Farbstoffzelle austreten. Mithin dient die Versiegelung der gegenüber der Umgebung offenen Bereiche der organischen Farbstoffzelle.

Glaslot ist ein Glas mit besonders niedriger Erweichungstemperatur, vorzugsweise etwa 400 °C, das zum thermischen Verbinden oder Abdichten von Gegenständen verwendet werden kann. Die Hauptbestandteile von Glaslot sind vorzugsweise Bor und Bleioxid. Vorzugsweise wirkt die mit dem erfindungsgemäßen Verfahren aufgebrachte elektrisch leitfähige Beschichtung als Kathode oder Anode des wenigstens einen Photovoltaikmoduls oder Optoelektronikmoduls.

Nachfolgend wird die Erfindung durch Beispiele und Figuren veranschaulicht, ohne jedoch den Umfang der Erfindung zu begrenzen.

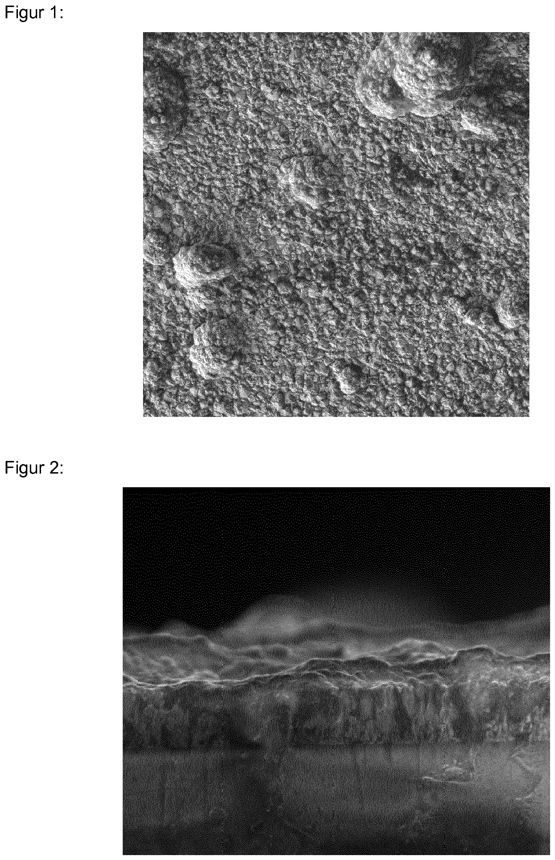

Figur 1 zeigt die Rasterelektronenmikroskop (REM) Aufnahme der in Beispiel 9 erzeugten kristallines Wolfram-dotiertes Zinn(IV)-Oxid-haltigen Schicht mit 5000-facher Vergrößerung.
Figur 2 zeigt die Rasterelektronenmikroskop (REM) Aufnahme eines Querschnitts durch die in Beispiel 9 erzeugte kristallines Wolfram-dotiertes Zinn(IV)-Oxid-haltige Schicht mit 5000-facher Vergrößerung.

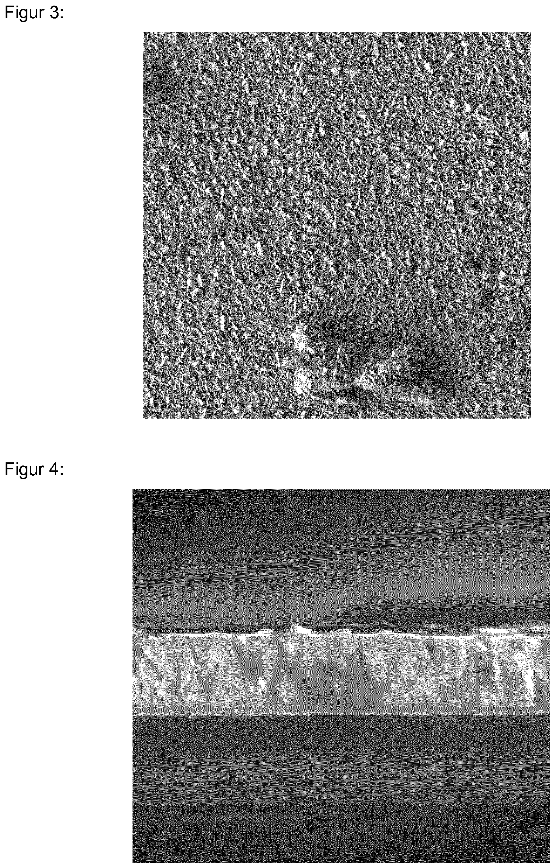

Figur 3 zeigt die Rasterelektronenmikroskop (REM) Aufnahme der in Beispiel 15 erzeugten kristallines Wolfram-dotiertes Zinn(IV)-Oxid-haltigen Schicht mit 5000-facher Vergrößerung.
Figur 4 zeigt die Rasterelektronenmikroskop (REM) Aufnahme eines Querschnitts durch die in Beispiel 15 erzeugte kristallines Wolfram-dotiertes Zinn(IV)-Oxid-haltige Schicht mit 5000-facher Vergrößerung.

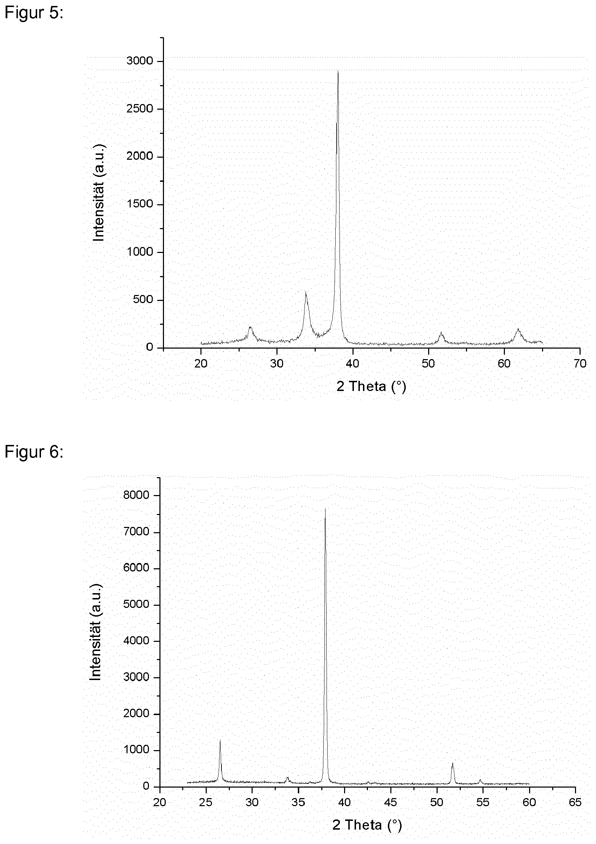

Figur 5 zeigt ein Röntgendiffraktogramm der in Beispiel 9 erzeugten kristallines Wolfram-dotiertes Zinn(IV)-Oxid-haltigen Schicht.
Figur 6 zeigt ein Röntgendiffraktogramm der in Beispiel 15 erzeugten kristallines Wolfram-dotiertes Zinn(IV)-Oxid-haltigen Schicht.

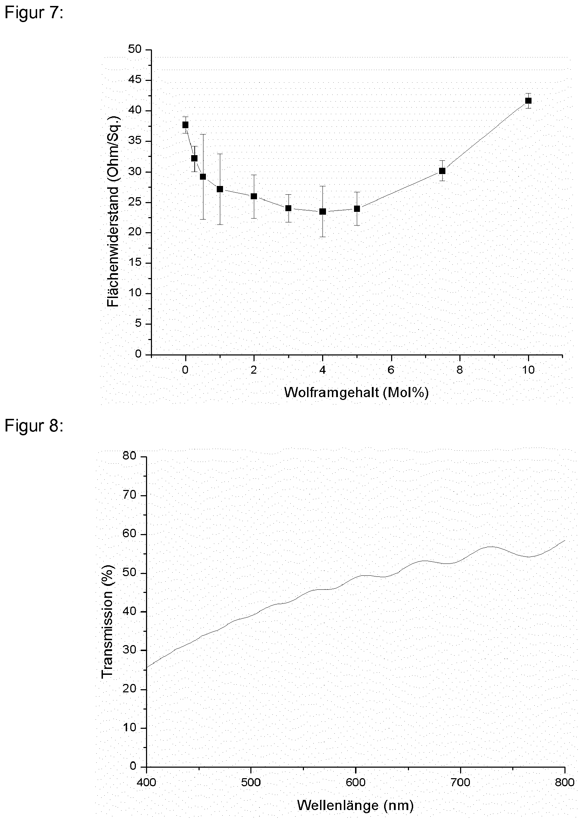

Figur 7 zeigt die Abhängigkeit des Flächenwiderstandes vom Wolframgehalt der in Beispiel 15 erzeugten kristallines Wolfram-dotiertes Zinn(IV)-Oxid-haltigen Schichten.
Figur 8 zeigt UV-VIS Transmissionsspektren, die an der in Beispiel 9 erzeugten kristallines Wolfram-dotiertes Zinn(IV)-Oxid-haltigen Schicht in einem Wellenlängenbereich von 400 nm bis 800 nm gemessen wurden.
Figur 9 zeigt einen schematischen Aufbau eines Photovoltaikmoduls, das als organische Farbstoffzelle ausgebildet ist.

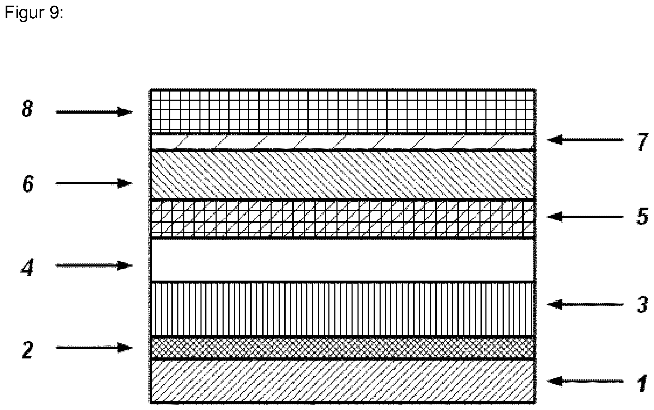

Bei der in Figur 9 dargestellten bevorzugten Ausführungsform der Erfindung ist zwischen der elektrisch leitfähigen Beschichtung 3 und dem Substrat 1 wenigstens eine Schutzschicht 2 angeordnet. Weiterhin ist auf der erfindungsgemäß hergestellten elektrisch leitfähigen Beschichtung 3 zunächst wenigstens eine Platin-haltige oder Platin-Schicht 4 oder Graphitschicht 4 angeordnet. Zwischen der Platin-haltigen oder Platin-Schicht 4 oder Graphitschicht 4 und der wenigstens einen porösen Schicht 6 ist die wenigstens eine Elektrolytschicht 5 angeordnet.

Auf der wenigstens einen porösen Schicht 6 ist eine transparente, elektrisch leitfähige Elektrode angeordnet, wobei die transparente, elektrisch leitfähige Elektrode eine transparente, elektrisch leitfähige Beschichtung 7 und ein transparentes Substrat 8 aufweist und die transparente, leitfähige Beschichtung 7 die wenigstens eine poröse Schicht 6 kontaktiert.

In der Figur 9 sind die elektrischen Kontakte der transparenten, elektrisch leitfähigen Beschichtung 7 und der elektrisch leitfähigen Beschichtung 3 sowie die Versiegelung der Randbereiche des Photovoltaikmoduls nicht dargestellt.

### Bezugszeichenliste:

- 1: Substrat
- 2: Schutzschicht
- 3: elektrisch leitfähige Beschichtung
- 4: Platin-haltige oder Platin-Schicht bzw. Graphit-haltige oder Graphitschicht
- 5: Elektrolytschicht
- 6: poröse Schicht, die wenigstens einen lichtempfindlichen Farbstoff enthält
- 7: transparente, elektrisch leitfähige Beschichtung
- 8: transparentes Substrat

### Beispiele

In den Beispielen 1 bis 14 wird jeweils die Herstellung einer Wolfram-dotierten Zinn(IV)-Oxid Schicht mittels Sprühpyrolyse unter den jeweils angegebenen Bedingungen veranschaulicht. In Beispiel 15 erfolgt die Herstellung einer Wolfram-dotierten Zinn(IV)-Oxid Schicht unter Einwirkung eines Ultraschallfeldes. Als Trägergas wurde, wenn angegeben, stets Druckluft verwendet.

### Beispiel 1:

Zunächst wurden 100 mL Ethanol vorgelegt und darin 8,77 g (0,025 mol) SnCl₄·5H₂O unter Rühren gelöst. Es bildete sich eine klare, farblose Lösung. Anschließend wurden 0,307 g (0,77 mmol) WCl₆ unter Rühren zugegeben. Die sodann erhaltene klare, gelbe Lösung ließ man für 24 Stunden bei 20 °C altern. Die erhaltene Vorläuferlösung, die jetzt drei Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad Electronic SE, D-92240 Hirschau) aufgesprüht.

### Beispiel 2:

Zunächst wurden 100 mL Ethanol vorgelegt und darin 8,77 g (0,025 mol) SnCl₄·5H₂O unter Rühren gelöst. Es bildete sich eine klare, farblose Lösung. Anschließend wurden 0,202 g (0,51 mmol) WCl₆ unter Rühren zugegeben. Die sodann erhaltene klare, gelbe Lösung ließ man für 24 Stunden bei 20 °C altern. Die erhaltene Vorläuferlösung, die jetzt zwei Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Beispiel 3:

Zunächst wurden 100 mL Ethanol vorgelegt und darin 8,77 g (0,025 mol) SnCl₄·5H₂O unter Rühren gelöst. Es bildete sich eine klare, farblose Lösung. Anschließend wurden 0,100 g (0,25 mmol) WCl₆ unter Rühren zugegeben. Die sodann erhaltene klare, gelbe Lösung ließ man für 24 Stunden bei 20 °C altern. Die erhaltene Vorläuferlösung, die jetzt 1 Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Beispiel 4

Zunächst wurden 100 mL Ethanol vorgelegt und darin 8,77 g (0,025 mol) SnCl₄·5 H₂O unter Rühren gelöst. Es bildet sich eine klare, farblose Lösung. Anschließend wurde 0,521 g (1,32 mmol) WCl₆ unter Rühren zugegeben. Die sodann erhaltene klare, gelbe Lösung ließ man für 24 Stunden bei 20 °C altern. Die erhaltene Vorläuferlösung, die jetzt fünf Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Beispiel 5:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 1,102 g (2,78 mmol) WCl₆ unter Rühren zugegeben. Die sodann erhaltene klare, gelbe Lösung ließ man für 24 Stunden bei 20 °C altern. Die erhaltene Vorläuferlösung, die jetzt zehn Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Beispiel 6:

Die Herstellung der Wolfram-dotierten Zinn(IV)-Oxidschichten erfolgte wie in Beispiel 1 beschrieben, wobei das Aufsprühen jedoch in zwei Intervallen (2 x 25s), zu je 25 Sprühstößen, erfolgte, wobei jeder Sprühstoß von einer Sekunde Dauer war und zwischen den Stößen jeweils eine Sekunde Pause gemacht wurde. Nach jedem Intervall wurde das mittlerweile abgekühlte Natron-Kalk-Glas-Substrat (Größe:4,5 cm x 4,5 cm) erneut auf eine Temperatur von 460 °C aufgeheizt. Durch Verlängerung der Sprühdauer ließen sich gut kontrollierbar dickere Schichten erzeugen.

### Beispiel 7:

Die Herstellung der Wolfram-dotierten Zinn(IV)-Oxidschichten erfolgte wie in Beispiel 1 beschrieben, wobei das Aufsprühen jedoch in drei Intervallen (3 x 25s), zu je 25 Sprühstößen, erfolgte, wobei jeder Sprühstoß von einer Sekunde Dauer war und zwischen den Stößen jeweils eine Sekunde Pause gemacht wurde. Nach jedem Intervall wurde das mittlerweile abgekühlte Natron-Kalk-Glas-Substrat (Größe: 4,5 cm x 4,5 cm) erneut auf eine Temperatur von 460 °C aufgeheizt. Durch Verlängerung der Sprühdauer ließen sich gut kontrollierbar dickere Schichten erzeugen.

### Beispiel 8:

Die Herstellung der Wolfram-dotierten Zinn(IV)-Oxidschichten erfolgte wie in Beispiel 1 beschrieben, wobei das Aufsprühen jedoch in fünf Intervallen (5 x 25s), zu je 25 Sprühstößen, erfolgte, wobei jeder Sprühstoß von einer Sekunde Dauer war und zwischen den Stößen jeweils eine Sekunde Pause gemacht wurde. Nach jedem Intervall wurde das mittlerweile abgekühlte Natron-Kalk-Glas-Substrat (Größe: 4,5 cm x 4,5 cm) erneut auf eine Temperatur von 460 °C aufgeheizt. Durch Verlängerung der Sprühdauer ließen sich gut kontrollierbar dickere Schichten erzeugen.

### Beispiel 9:

Die Herstellung der Wolfram-dotierten Zinn(IV)-Oxidschichten erfolgte wie in Beispiel 1 beschrieben, wobei das Aufsprühen jedoch in sieben Intervallen (7 x 25s), zu je 25 Sprühstößen erfolgte, wobei jeder Sprühstoß von einer Sekunde Dauer war und zwischen den Stößen jeweils eine Sekunde Pause gemacht wurde. Nach jedem Intervall wurde das mittlerweile abgekühlte Natron-Kalk-Glas-Substrat (Größe:4,5 cm x 4,5 cm) erneut auf eine Temperatur von 460 °C aufgeheizt. Durch Verlängerung der Sprühdauer ließen sich gut kontrollierbar dickere Schichten erzeugen.

### Beispiel 10:

Zunächst wurden 100 mL Ethanol vorgelegt und darin 8,77 g (0,025 mol) SnCl₄·5H₂O unter Rühren gelöst. Es bildete sich eine klare, farblose Lösung. Anschließend wurden 0,307 g (0,77 mmol) WCl₆ unter Rühren zugegeben. Die sodann erhaltene klare, gelbe Lösung ließ man für 24 Stunden bei 20 °C altern. Die erhaltene Vorläuferlösung, die jetzt drei Mol-% Wolfram enthielt (bezogen auf den gesamten Metallionenanteil), wurde im Anschluss bei einem Druck von 0,5 bar, einer Substrattemperatur von 400 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Beispiel 11:

Zunächst wurden 100 mL Ethanol vorgelegt und darin 8,77 g (0,025 mol) SnCl₄ 5 H₂O unter Rühren gelöst. Es bildete sich eine klare, farblose Lösung. Anschließend wurden 0,307 g (0,77 mmol) WCl₆ unter Rühren zugegeben. Die sodann erhaltene klare, gelbe Lösung ließ man für 24 Stunden bei 20 °C altern. Die erhaltene Vorläuferlösung, die jetzt drei Mol-% Wolfram enthält (bezogen auf den gesamten Metallionenanteil), wurde im Anschluss bei einem Druck von 0,5 bar, einer Substrattemperatur von 500 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Beispiel 12:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 0,307 g (0,77 mmol) WCl₆ unter Rühren zugegeben. Die sodann klare, gelbe Lösung ließ man für 24 Stunden bei 20 °C altern. Die erhaltene Vorläuferlösung, die jetzt drei Mol-% Wolfram enthielt (bezogen auf den gesamten Metallionenanteil), wurde im Anschluss bei einem Druck von 0,5 bar, einer Substrattemperatur von 550 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Beispiel 13:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 0,307 g (0,77 mmol) WCl₆ unter Rühren zugegeben. Die sodann erhaltene klare, gelbe Lösung ließ man für 24 Stunden altern. Die erhaltene Vorläuferlösung, die jetzt drei Mol-% Wolfram enthielt (bezogen auf den gesamten Metallionenanteil), wurde im Anschluss bei einem Druck von 0,5 bar, einer Substrattemperatur von 600 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Beispiel 14:

Zunächst erfolgte die Synthese der Vorläuferlösung analog zu Beispiel 1. Diese wurde im Anschluss bei einem Druck von 0,5 bar, einer Substrattemperatur von 460 °C und in 25 Sprühstößen zu je einer Sekunde mit je einer Sekunde Pause auf ein keramisches Substrat (Dachziegelmaterial der ERLUS AG, Naturrot, Ergoldsbacher E58, Größe: 2cm x 2,5 cm) aufgesprüht.

### Beispiel 15:

Zunächst erfolgte die Synthese einer Vorläuferlösung analog zu Beispiel 1. Diese wurde dann mit Hilfe einer Ultraschalldüse bei einer Frequenz von 50,3 kHz und einer Leistung von 6 Watt (Hersteller: Sinaptec, Modell: Inside 200) zerstäubt und im Anschluss bei einem Vorläuferlösung-Volumenstrom von 1,2 mL pro Minute auf ein 460 °C heißes Natron-Kalk-Glas-Substrat (Größe: 2,25 cm x 2,25 cm) über einen Zeitraum von 136 Sekunden aufgedampft. Die Oberflächentemperatur wurde konstant bei 460 °C gehalten.

### Ergebnis

Die so hergestellten Beschichtungen wurden nach der Präparation mittels Röntgenstrukturanalyse (STOE Röntgendiffraktometer in θ-θ-Reflexionsgeometrie), UV/VIS Spektrophotometrie (Varian Carry 100 Bio), Elektronenmikroskopie (JEOL JSM-6700F) und elektrischer Widerstandsmessung (4-Punkt-Methode, Keithley 2400) charakterisiert. Dabei wurde festgestellt, dass sowohl Transparenz als auch Flächenwiderstand und spez. Widerstand von den Schichtdicken der Filme abhängen. Das Ergebnis der Charakterisierung der gemäß Beispiel 1 sprühpyrolytisch aufgetragenen Wolfram(VI)dotierten Zinn(IV)-dioxidschicht ist in Tabelle 1 angegeben:

**Tabelle 1: Eigenschaften der gemäß Beispielen 1, 7, 8, 9 und15 sprühpyrolytisch abgeschiedenen Wolfram(VI) dotierten Zinn(IV)-Oxidschichten.**

| Parameter | Beispiel 1 | Beispiel 7 | Beispiel 8 | Beispiel 9 | Beispiel 15 |
|---|---|---|---|---|---|
| Methode | SP | SP | SP | SP | USP |
| Schichtdicke (nm) | 246 | 714 | 1205 | 1717 | 1232 |
| Flächenwiderstand (Ω/Sq.) | 231 | 54 | 33 | 20 | 24 |
| Spez. Widerstand (Ω x cm) | 5,68 x 10⁻³ | 3,86 x 10⁻³ | 3,98 x 10⁻³ | 3,43 x 10⁻³ | 2,96 x 10⁻³ |
| Optische Transparenz (%) | 86 | 74 | 56 | 42 | 65 |

Der Vorteil des erfindungsgemäßen sprühpyrolytischen (SP) Verfahrens zur Auftragung transparent leitfähiger Wolfram(VI) dotierter Zinn(IV)-Oxidschichten liegt zum einen darin, dass der Einsatz des teuren Material Indium (das üblicherweise zur Herstellung solcher Schichten eingesetzt wird) vermieden wird.

Aus der CN 101413099 A sind Wolfram(VI) dotierte Zinn(IV)-oxidschichten bekannt. Dort erfolgt die Herstellung transparent leitfähiger Wolfram(VI) dotierter Zinn(IV)-Oxidschichten mittels Puls-Plasma-Abscheidung (PPD):
Gemäß der Lehre der CN 101413099 A wurden zur Herstellung eines Wolfram-Zinnoxid-Targets (Wolframgehalt 2 Gew%) zunächst die entsprechenden Oxide vermischt und gemahlen. Im Anschluss wurde das Stoffgemisch bei 800 °C für 12 Stunden kalziniert und nach dem Abkühlen auf Raumtemperatur für 10 Minuten bei einem Druck von 13 MPa zu einem 3mm dicken Pressling verarbeitet. Dieser wurde im Anschluss in Wasser und Ethanol unter Einfluss von Ultraschall gereinigt. Sodann erfolgte die Abscheidung bei einem Druck von 2,5 Pa in einer Vakuumkammer bei Raumtemperatur auf einem Quarzglassubstrat. Die Abscheidungsdauer lag bei 20 Minuten, und im Anschluss wurde eine Kalzination bei 800 °C in Luft durchgeführt. Die erhaltene Schichtdicke nach der Abscheidung lag bei 109 nm, bei einer optischen Transparenz (sichtbarer Bereich des Lichtes) von 81% und einem spezifischen Widerstand von 7,83 x 10⁻⁴ Ohm x cm.

Im Unterschied zur Lehre der CN 101413099 weist die erfindungsgemäß hergestellte Beschichtung eine wesentlich größere Schichtdicke auf. Wie Tabelle 2 entnommen werden kann, ist die optische Transparenz der erfindungsgemäß hergestellten Beschichtung, verglichen mit der Beschichtung gemäß der Lehre der CN 101413099, wesentlich größer.

In Tabelle 2 sind wesentliche Parameter des Verfahrens gemäß der vorliegenden Erfindung und der CN 101413099 A gegenübergestellt. Da die sprühpyrolytisch abgeschiedenen erfindungsgemäß hergestellten Beschichtungen dicker sind als die mittels PPD abgeschiedenen, wurden die Parameter der erfindungsgemäß hergestellten Beschichtung rechnerisch für eine geringere Schichtdicke extrapoliert, um einen direkten Vergleich zu ermöglichen. Die Schichtdicke der sprühpyrolytisch abgeschiedenen Schicht betrug 250 nm (siehe Tabelle 1).

**Tabelle 2: Vergleich der Erfindung mit CN 101413099 A.**

| Parameter | Erfindung (extrapoliert) | CN 101413099 A |
|---|---|---|
| Verfahren | SP | PPD |
| Schichtdicke | 109 nm (heruntergerechnet) | 109 nm |
| Flächenwiderstand | 520 Ω/Sq. | 71 Ω/Sq. |
| Spez. Widerstand | 5,7 x 10⁻³ Ω x cm | 7,83 x 10⁻⁴ Ω x cm |
| Optische Transparenz | 95% | 81% |
| Nachbehandlung | Nein | Ja (3h, 800 °C) |
| Auftragungsdauer | ∼12 Sekunden | 20 Minuten |

Es ist zu erkennen, dass die Flächenwiderstände und damit auch die spezifischen Widerstände der mittels PPD hergestellten Filme bei gleicher Schichtdicke niedriger sind als bei den mittels Sprühpyrolyse hergestellten Filmen (Beschichtungen).

Ein großer Vorteil des erfindungsgemäßen Verfahrens ist, dass die erfindungsgemäß hergestellte Beschichtung verfahrenstechnisch schnell und mit sehr niedrigem Aufwand erzeugt werden kann. Die erfindungsgemäß hergestellte Beschichtung weist dabei eine deutlich größere Schichtdicke auf, die in einem Bereich von 170 bis 5000 nm liegt. Die Auftragsdauer bei dem erfindungsgemäßen Verfahren ist mit etwa 12 Sekunden nur ein winziger Bruchteil der gemäß der Lehre der CN 101413099 A erforderlichen Zeitdauer von 20 Minuten.

Zusätzlich muss bei dem erfindungsgemäßen Verfahren keine Target-Herstellung erfolgen und keine nachträgliche Kalzination durchgeführt werden. Neben der äußerst geringen Abscheidungsdauer bei dem erfindungsgemäßen Verfahren ist insbesondere der apparative Aufwand sehr viel geringer. Im Unterschied zu dem PPD-Verfahren kann auf ein sehr kostenintensives Vakuumverfahren verzichtet werden.

## Patentansprüche

1. Verfahren zum Herstellen einer elektrisch leitfähigen Beschichtung umfassend kristallines Wolfram-dotiertes Zinnoxid,
**dadurch gekennzeichnet,**
**dass** das Verfahren den folgenden Schritt umfasst:
Sprühpyrolysieren einer Lösung, die in einem Lösungsmittel wenigstens eine lösliche Zinnverbindung und wenigstens eine lösliche Wolframverbindung enthält, in Gegenwart von Sauerstoff oder Sauerstoff-abgebender/en Verbindung(en) unter Erzeugung einer kristallines Wolfram-dotiertes Zinnoxid-haltigen Schicht, wobei das Sprühpyrolysieren in Intervallen von 0,1 bis 10 Sekunden erfolgt und die elektrisch leitfähige Beschichtung eine Schichtdicke aus einem Bereich von 170 bis 5000 nm aufweist.

2. Verfahren nach Anspruch 1,
**dadurch gekennzeichnet,**
**dass** als Lösungsmittel organisches Lösungsmittel verwendet wird, wobei das organische Lösungsmittel vorzugsweise weniger als 15 Vol.-% Wasser, bezogen auf das Gesamtvolumen des Lösungsmittels, enthält.

3. Verfahren nach einem der Ansprüche 1 oder 2,
**dadurch gekennzeichnet,**
**dass** als lösliche Zinnverbindung und als lösliche Wolframverbindung Salze verwendet werden.

4. Verfahren nach einem der Ansprüche 1 bis 3,
**dadurch gekennzeichnet,**
**dass** während der Sprühpyrolyse Ultraschall eingestrahlt wird.

5. Verfahren nach einem der Ansprüche 1 bis 4,
**dadurch gekennzeichnet,**
**dass** die Lösung, die in einem Lösungsmittel wenigstens eine lösliche Zinnverbindung und wenigstens eine lösliche Wolframverbindung enthält, Wolfram in einem Anteil von 0,1 bis 20 Molprozent, vorzugsweise 1 bis 5 Molprozent, jeweils bezogen auf die Gesamtstoffmenge an Wolfram und Zinn, enthält.

## Claims

1. Method for manufacturing an electrically conductive coating comprising crystalline tungsten-doped tin oxide,
**characterised in that**
the method comprises the following step:
spray pyrolyzing a solution, which contains at least one soluble tin compound and at least one soluble tungsten compound in a solvent, in the presence of oxygen or oxygen-releasing compound(s) generating a crystalline tungsten-doped layer containing tin oxide, wherein the spray pyrolyzing takes place in intervals of 0.1 to 10 seconds, and the electrically conductive coating has a layer thickness from a range of from 170 to 5000 nm.

2. Method according to claim 1,
**characterised in that**
an organic solvent is used as the solvent, wherein the organic solvent preferably contains less than 15 vol. % water, with respect to the total volume of the solvent.

3. Method according to one of claims 1 or 2,
**characterised in that**
salts are used as the soluble tin compound and as the soluble tungsten compound.

4. Method according to one of claims 1 to 3,
**characterised in that**
ultrasound is irradiated during the spray pyrolyzing.

5. Method according to one of claims 1 to 4,
**characterised in that**
the solution, which contains at least one soluble tin compound and at least one soluble tungsten compound in a solvent, contains tungsten in a proportion of from 0.1 to 20 mole percent, preferably from 1 to 5 mole percent, in each case relative to the total amount of substance of tungsten and tin.

## Revendications

1. Procédé de fabrication d'un revêtement conducteur de l'électricité, comprenant de l'oxyde d'étain cristallin dopé au tungstène, **caractérisé en ce que** le procédé comprend l'étape suivante :
pyrolyser par pulvérisation une solution qui contient dans un solvant au moins un composé soluble de l'étain et au moins un composé soluble du tungstène, en présence d'oxygène ou d'un ou plusieurs composés qui cèdent de l'oxygène, avec production d'une couche contenant de l'oxyde d'étain cristallin dopé au tungstène, dans lequel la pyrolyse par pulvérisation est réalisée à des intervalles de 0,1 à 10 secondes, et le revêtement conducteur de l'électricité présente une épaisseur de couche comprise dans la plage de 170 à 5000 nm.

2. Procédé selon la revendication 1, **caractérisé en ce qu'**on utilise en tant que solvant un solvant organique, dans lequel le solvant organique contient de préférence moins de 15 % en volume d'eau, par rapport au volume total du solvant.

3. Procédé selon l'une des revendications 1 ou 2, **caractérisé en ce qu'**on utilise des sels en tant que composé soluble de l'étain et en tant que composé soluble du tungstène.

4. Procédé selon l'une des revendications 1 à 3, **caractérisé en ce qu'**on envoie des ultrasons pendant la pyrolyse par pulvérisation.

5. Procédé selon l'une des revendications 1 à 4, **caractérisé en ce que** la solution contient dans un solvant au moins un composé soluble de l'étain et au moins un composé soluble du tungstène, le tungstène y étant contenu selon une proportion de 0,1 à 20 pourcents en moles, de préférence de 1 à 5 pourcents en moles, dans chaque cas par rapport à la quantité totale de tungstène et d'étain.
